# EUROPEAN PATENT APPLICATION

(11) **EP 1 542 249 A2**
(43) Date of publication of application: **15.06.2005**
(21) Application number: 04090491.4
(22) Date of filing: 13.12.2004
(51) Int. Cl.: H01G 9/20

(54) **Dye-sensitized solar cell and fabrication method thereof**

(30) Priority: 12.12.2003 KR 2003090649
(71) Applicant: Samsung SDI Co., Ltd., Suwon-si, Gyeonggi-do (KR)
(72) Inventor: Choi, Jae-Man, Legal & IP Team, Yongin-City Kyeonggi-Do (KR); Lee, Ji-Won, Legal & IP Team, Yongin-City Kyeonggi-Do (KR); Lee, Wha-Sup, Legal & IP Team, Yongin-City Kyeonggi-Do (KR); Ahn, Kwang-Soon, Legal & IP Team, Yongin-City Kyeonggi-Do (KR); Shin, Byong-Cheol, Legal & IP Team, Yongin-City Kyeonggi-Do (KR); Park, Joung-Won, Legal & IP Team, Yongin-City Kyeonggi-Do (KR)
(74) Representative: Hengelhaupt, Jürgen, Dipl.-Ing.

(57) **Abstract**

Disclosed is a dye-sensitized solar cell with enhanced photoelectric conversion efficiency. The dye-sensitized solar cell includes a first electrode of a light transmission material, a second electrode facing the first electrode, and a dye-absorbed porous layer formed on the first electrode. An electrolyte is injected between the first and the second electrodes. The porous layer contains first and second materials differing from each other in conduction band energy level.

## Description

### CROSS-REFERENCE TO RELATED APPLICATION

This application claims priority to and the benefit of Korean Patent Application No. 10-2003-0090649 filed on December 12, 2003 in the Korean Intellectual Property Office, the entire content of which is incorporated herein by reference.

### FIELD OF THE INVENTION

The present invention relates to a dye-sensitized solar cell, and in particular, to a dye-sensitized solar cell with enhanced energy efficiency, and a method of fabricating the same.

### BACKGROUND OF THE INVENTION

A dye-sensitized solar cell is a cell which converts solar energy into electric energy based on photosynthesis, thereby achieving the desired energy efficiency.

A prominent study of dye-sensitized solar cells was made by Michael Gratzel of Ecole Polytechnique Federale de Lausanne (EPFL, Switzerland) in 1991. The dye-sensitized solar cell proposed by Gratzel uses anatase titanium oxide having a nanometer-leveled particle diameter.

The production of dye-sensitized solar cells generally involves relatively easy processing steps and low production cost compared to the production of conventional silicon solar cells. As dye-sensitized solar cells are formed with transparent electrodes, they may be used in making windows for the outer walls of buildings, or in making glass houses.

However, dye-sensitized solar cells tend to have lower photoelectric conversion efficiencies compared to conventional silicon solar cells which limits their practical use. As the photoelectric conversion efficiency of a solar cell is directly proportional to the amount of electrons generated due to the absorption of sunlight, the efficiency may be improved by increasing the amount of electrons or by preventing the electrons and holes from being recombined. For this purpose, the sunlight absorption of the solar cell or the dye absorption thereof should be increased.

It has been proposed that the platinum electrode reflectivity should be increased or that light scattering particles should be used to increase the sunlight absorption, or that semiconductor oxide particles should be dimensioned up to the nanometer level to increase the dye absorption. However, such techniques are limited in enhancing the photoelectric conversion efficiency of the solar cell.

### SUMMARY OF THE INVENTION

In one embodiment of the present invention, a dye-sensitized solar cell is provided which inhibits the recombination of electrons and holes while increasing the accumulation of charged particles, thereby enhancing photoelectric conversion efficiency.

According to one embodiment of the present invention, a dye-sensitized solar cell includes a first electrode of a light transmission material, and a porous layer formed on a surface of the first electrode. The porous layer comprises first and second materials differing from each other in conduction band energy level. A dye is absorbed on the porous layer. A second electrode faces the surface of the first electrode and an electrolyte is impregnated between the first and the second electrodes.

The first material is formed with metal oxides, and the second material has a conduction band energy level higher than the conduction band energy level of the first material.

The first material is selected from the group consisting of Ti oxide, Zr oxide, Sr oxide, Zn oxide, In oxide, Ir oxide, La oxide, V oxide, Mo oxide, W oxide, Sn oxide, Nb oxide, Mg oxide, Al oxide, Y oxide, Sc oxide, Sm oxide, Ga oxide, SrTi oxide, and combinations thereof.

The second material is selected from the group consisting of metal oxides, GaP, SiC, CdS, and combinations thereof. In one embodiment, the second material is selected from the group consisting of Ti oxide, Zr oxide, Sr oxide, Zn oxide, In oxide, Ir oxide, La oxide, V oxide, Mo oxide, W oxide, Sn oxide, Nb oxide, Mg oxide, Al oxide, Y oxide, Sc oxide, Sm oxide, Ga oxide, SrTi oxide, GaP, SiC, CdS, and combinations thereof.

In still another embodiment, the first material is Ti oxide, and the second material is selected from the group consisting of Sr oxide, Nb oxide and Zn oxide.

According to one embodiment, the conduction band energy level of the first material is between about -8.5 and -3.5 eV, and the conduction band energy level of the second material is between about -8.0 and -3.0eV.

In yet another embodiment, the first and the second materials are formed with particles having a mean particle diameter of 100nm or less, and preferably between about 10 and 40nm.

The dye contains a metal complex of Ru and another metal selected from the group consisting of Al, Pt, Pd, Eu, Pb and Ir.

The porous layer contains conductive particles or light scattering particles.

The first electrode includes a first transparent substrate. Examples of the materials used for the first transparent substrate include materials selected from the group consisting of polyethylene terephthalate (PET), polyethylene naphthalate (PEN), polycarbonate (PC), polypropylene (PP), polyimide (PI), and triacetate cellulose (TAC). A first conductive film is located over the first transparent substrate. Examples of the materials used for the first conductive film include materials selected from the group consisting of indium tin oxide (ITO), fluorine tin oxide (FTO), ZnO-Ga₂O₃, ZnO-Al₂O₃, and SnO₂-Sb₂O₃.

The second electrode also includes a second transparent substrate with a second conductive film over it. Examples of the materials used for the second transparent substrate include materials selected from the group consisting of polyethylene terephthalate (PET), polyethylene naphthalate (PEN), polycarbonate (PC), polypropylene (PP), polyimide (PI) and triacetate cellulose (TAC). According to one embodiment of the invention, the second conductive film is a two-layer conductive film with a first layer applied to the second transparent substrate and a second layer applied to the first layer. Examples of the materials used for the first layer of the conductive film formed on the second substrate include materials selected from the group consisting of indium tin oxide (ITO), fluorine tin oxide (FTO), ZnO-Ga₂O₃, ZnO-Al₂O₃ and SnO₂-Sb₂O₃. Examples of the materials used for the second layer of the conductive film include Pt or other precious metal such as gold, silver, ruthenium, rhodium, palladium, osmium and iridium.

According to an embodiment of the present invention, the dye-sensitized solar cell includes a porous layer formed on the conductive film of the first electrode. The porous layer comprises first and second materials differing from one another in conduction band energy level. According to this embodiment, the second material is formed on the surface of the first material. A dye is then absorbed on the porous layer. The electrodes are arranged such that the conductive film layer of the second electrode faces the porous layer of the first electrode. An electrolyte is impregnated between the first and the second electrodes to produce a dye-sensitized solar cell.

In one embodiment, the second material of the porous layer is formed on the surface of the first material as a thin film. The second material may have a film thickness between about 5 and 100 nm.

In a method of fabricating the dye-sensitized solar cell, first and second electrodes are prepared as set forth above. A mixture of first and second materials differing from each other in conduction band energy level is prepared, and the mixture is coated onto the conductive layer surface of the first electrode to form a porous layer comprising the first and the second materials. A dye is absorbed on the porous layer. The second electrode is aligned with the first electrode such that the conductive layer of the second electrode faces the porous layer of the first electrode. An electrolyte is injected between the first and second electrode, and the first and second electrodes are attached to each other.

In forming the porous layer, the first and second materials are added to a solvent to make a mixed solution. A polymer is then added to the mixed solution to form a slurry. The slurry mixture is then coated onto the conductive film layer of the first electrode and dried.

In one embodiment of the invention, about 5 to 30 wt.% of titanium oxide and about 0.1 to 20 wt.% with respect to the titanium oxide of strontium oxide are added to about 70 to 95 wt.% of a solvent. Suitable solvents include water, ethanol, methanol and mixtures thereof. To this mixture, about 5 to 50 wt.% with respect to the titanium oxide of polyethylene glycol or polyethylene oxide is added to form a slurry. The slurry is then coated onto the first electrode at a thickness of about 1 to 50 µm and dried. Suitable coating techniques include screen printing techniques or application with a doctor blade.

In another embodiment of the invention, precursors of the first and second materials are added to a solvent, and heated to promote a chemical reaction by which a mixed solution of the first and second materials is produced. A polymer is added to the mixed solution to form a slurry. The slurry is then coated onto the conductive film layer of the first electrode, and dried.

According to this embodiment, about 5 to 10 wt.% of titanium isopropoxide (Ti(i-Pro)₄) and about 0.1 to 20wt.% with respect to the titanium isopropoxide of strontium isopropoxide (Sr(i-Pro)₂) are added to a solvent comprising about 90 to 95wt.% of the total solution to produce a reactant mixture. Suitable solvents include water, ethanol, methanol or combinations thereof. The reactant mixture is heated to about 250 to 350°C at a pH of between about 1 and 2 to promote a chemical reaction and thereby produce a product mixture containing titanium oxide and strontium oxide. About 5 to 50 wt.% with respect to the titanium oxide of polyethylene glycol or polyethylene oxide is added to the product mixture to form a slurry. The slurry is coated onto the conductive film of the first electrode at a thickness between about 1 and 50 µm, and dried. Suitable coating techniques include screen printing or application with a doctor blade.

In order to dry the slurry and cause the formation of the first material and/or second material from precursors of the materials, the first electrode is heat-treated to a temperature of about 400°C or more under an air or oxygen atmosphere.

In yet another embodiment of the invention the porous layer is formed by coating a slurry containing the first material, a solvent, and a polymer onto the first electrode, and drying the coated electrode. The coated and dried electrode is then dipped into a solution containing the second material, and dried again to form the porous layer comprising the first and second materials. A dye then is absorbed on the porous layer. A second electrode is aligned with the first electrode with the second electrode facing the porous layer of the first electrode. An electrolyte is injected between the first and the second electrodes, and the first and the second electrodes are attached to each other to form a dye-sensitized solar cell.

According to this embodiment, the slurry comprises about 5 to 30 wt.% of titanium oxide as the first material, about 5 to 50 wt.% with respect to the titanium oxide of polyethylene glycol or polyethylene oxide as the polymer, and about 70 to 95wt.% of a solvent. Suitable solvents include water, ethanol, methanol and mixtures thereof. The slurry is coated onto a surface of the first electrode at a thickness between about 1 and 50 µm such as by a screen printing technique or by a doctor blade, and the coated electrode is dried.

Then, about 40wt.% of strontium nitrate (Sr(NO₃)₂) as a precursor to the second material is dissolved in water to form a solution, and the first electrode with the porous layer containing the titanium oxide is dipped into the solution for about 30 minutes. The coated electrode is then heated to promote a chemical reaction to form the first material.

In yet another embodiment of the invention, the first material is formed by mixing a precursor of the first material with a solvent, and heating the mixture to produce a mixture containing the first material. A polymer is added to this mixture to form a slurry which is coated onto a surface of the first electrode, and dried.

In still another embodiment of the invention, the first material is formed by coating the electrode with a slurry comprising a precursor of the first material, a polymer, and a solvent, and coating the electrode with the slurry. The coated electrode is then heated to promote a chemical reaction to form the first material.

According to still another embodiment of the invention, a porous layer is formed by adding about 5 to 10 wt.% of titanium isopropoxide (Ti(i-Pro)₂) as a precursor to the first material to about 90 to 95 wt.% of a solvent. Suitable solvents include water, ethanol, methanol and combinations thereof. The mixture is heated to between about 250 and 350°C at a pH of from about 1 to 2 to produce a colloid in which titanium oxide is diffused. About 5 to 50 wt.% with respect to the titanium oxide of a polymer such as polyethylene glycol or polyethylene oxide is added to the colloid to make a slurry. The slurry is then coated onto a surface of the first electrode at a thickness of between about 1 to 50 µm such as by using a screen printing technique or by a doctor blade, and dried.

For those embodiments in which the porous layer is formed with just the first material, the coated electrode is dipped into a solution of about 40wt.% of a precursor to the second material such as strontium nitrate (Sr(NO3)2) for about 30 minutes. The electrode is then dried at about 400°C or more under an air or oxygen atmosphere to cause the reaction of the precursor to form strontium oxide as the second material.

As described in the embodiments above, the dye-sensitized solar cell according to the present invention has a porous layer with first and second materials differing from each other in conduction band energy level. The second material forms an energy barrier between the first material and the dye molecules, thereby inhibiting the recombination of electrons and holes, and improving the charge accumulation effect. Accordingly, the energy efficiency of the solar cell is enhanced by 35% or more over conventional solar cells that include a porous layer based on a single material. Furthermore, the commercialization of such dye-sensitized solar cells is improved

### BRIEF DESCRIPTION OF THE DRAWINGS

The above and other advantages of the present invention will become more apparent by describing preferred embodiments thereof in detail with reference to the accompanying drawings in which:

Fig. 1 is a cross sectional view of a dye-sensitized solar cell according to an embodiment of the present invention;

Fig. 2 is a cross sectional view of a dye-sensitized solar cell according to another embodiment of the present invention;

Figs. 3A and 3B illustrate the energy level of a porous layer and a dye with dye-sensitized solar cells according to the Example and the Comparative Example; and

Fig. 4 is a voltage-current density graph illustrating the measurements of the photoelectric conversion efficiency of the solar cells according to the Example and the Comparative Example.

### DETAILED DESCRIPTION

The present invention will be described more fully hereinafter with reference to the accompanying drawings, in which preferred embodiments of the invention are shown.

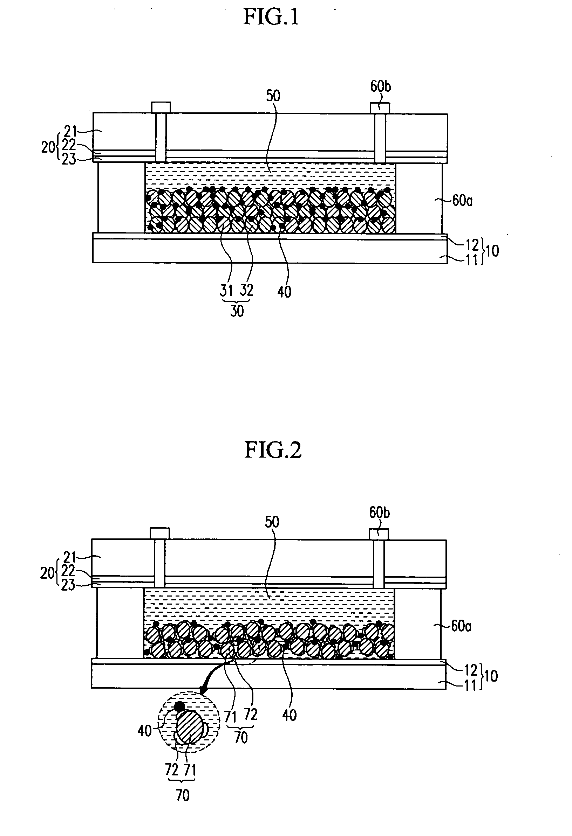

Fig. 1 is a cross sectional view of a dye-sensitized solar cell according to an embodiment of the present invention.

As shown in Fig. 1, the dye-sensitized solar cell includes a first electrode 10 and a second electrode 20 spaced apart from one another. A porous layer 30 is formed on the surface of the first electrode 10 facing the second electrode 20, and a dye 40 is absorbed on the porous layer 30. An electrolyte 50 is impregnated between the first and the second electrodes 10 and 20 to produce a dye-sensitized solar cell.

The first electrode 10 includes a transparent substrate 11, and a conductive film 12 coated on the substrate 11. Suitable materials for the substrate 11 include polyethylene terephthalate (PET), polyethylene naphthalate (PEN), polycarbonate (PC), polypropylene (PP), polyimide (PI), and triacetate cellulose (TAC). The conductive film 12 is formed from a material such as indium tin oxide (ITO), fluorine tin oxide (FTO), ZnO-Ga₂O₃, ZnO-Al₂O₃, or SnO₂-Sb₂O₃.

A porous layer 30 is formed on the surface of the first electrode 10 facing the second electrode 20. The porous layer 30 contains first and second materials 31 and 32 differing from each other in conduction band energy level. The first and the second materials 31 and 32 are formed with particles having a nanometer-leveled mean particle diameter.

In one embodiment of the invention, the conduction band energy level of the first material is between about -8.5 and -3.5 eV, and that of the second material is between about -8.0 and -3.0 eV.

The first material 31 is selected from the group consisting of Ti oxide, Zr oxide, Sr oxide, Zn oxide, In oxide, Ir oxide, La oxide, V oxide, Mo oxide, W oxide, Sn oxide, Nb oxide, Mg oxide, Al oxide, Y oxide, Sc oxide, Sm oxide, Ga oxide, SrTi oxide, and combinations thereof.

The second material 32 has a conduction band energy level higher than that of the first material 31, and is selected from the group consisting of metal oxides, GaP, SiC, CdS, and combinations thereof. In one embodiment, the second material 32 is formed with a material selected from the group consisting of Ti oxide, Zr oxide, Sr oxide, Zn oxide, In oxide, Ir oxide, La oxide, V oxide, Mo oxide, W oxide, Sn oxide, Nb oxide, Mg oxide, Al oxide, Y oxide, Sc oxide, Sm oxide, Ga oxide, SrTi oxide, GaP, SiC, CdS, and combinations thereof.

In an embodiment of the invention, the first material is formed with titanium oxide, and the second material with strontium oxide, niobium oxide or zinc oxide. The nanometer-leveled oxide particles of the porous layer 30 preferably have even particle diameters to achieve a high porosity and an optimal surface roughness.

The nano particles of the porous layer 30 have a mean particle diameter of 100nm or less, preferably between about 10 and 40nm. When the mean particle diameter of the nano particles is less than 10nm, the adhesive force thereof is too weak to form the porous layer 30 in a stable manner. When the mean particle diameter of the nano particles exceeds 40nm, the surface area of the dye-absorbed porous layer 30 is reduced so that the photoelectric conversion efficiency is decreased.

According to one embodiment of the invention, the porous layer 30 is formed by coating the inner surface of the first electrode 10 with a slurry paste containing the first and the second materials, and heat-treating the coated first electrode 10.

Various coating methods can be used including use of a doctor blade or screen-printing techniques. In order to form the porous layer 30 as a transparent film, spin coating or spraying may be used. Furthermore, it is also possible to use a common wet coating technique for that purpose. The physical properties of the paste may be slightly modified dependent upon the relevant coating technique used, and such modifications would be apparent to one of ordinary skill in the art.

The paste may also include a binder. When a binder is added to the paste, the paste should be heat-treated at a temperature between about 400 and 600°C for about 30 minutes. Without a binder, it is possible to heat-treat the paste at about 200°C or less. The detailed description of the process for forming the porous layer 30 will be made later.

The porous layer 30 may further contain a polymer to maintain the porosity thereof. In this case, the polymer is added to the porous layer 30, and heat-treated at to between about 400 and 600°C to form a highly porous coating layer. The polymer is preferably selected from materials such that little organic material content is left after the heat treatment. Examples of such materials include polyethylene glycol (PEG), polyethylene oxide (PEO), polyvinyl alcohol (PVA), and polyvinyl pyrrolidone (PVP). In consideration of the coating conditions, a polymer with a proper molecular weight is selected, and added to the porous layer 30. When the polymer is added to the porous layer 30, the porosity increases, and the diffusion and the viscosity of the porous layer 30 also increase, thereby enhancing the film formation and the adhesive force of the substrate.

The porous layer 30 may further contain conductive particles or light scattering particles. The conductive particles have a role of easily migrating the electrons, and are formed with ITO. The light scattering particles have a role of enlarging the optical path length and enhancing the photoelectric conversion efficiency, and are formed with the same material as the porous layer while bearing a mean particle diameter of 100nm or more.

A dye 40 is absorbed on the surface of the nanometer-leveled particles of the porous layer 30. The dye 40 is formed with a material capable of absorbing visible rays, such as a complex of Ru and a metal selected from the group consisting of Al, Pt, Pd, Eu, Pb and Ir. Ruthenium (Ru) is an element of the platinum group, and is capable of forming a number of organic metal complex compounds.

The dye material for the solar cell is most commonly selected from the type of Ru(etc bpy)₂(NCS)₂ · 2CH₃CN. The "etc" is (COOEt)₂ or (COOH)₂ being a radical capable of bonding with the surface of the porous layer (for instance, based on TiO₂). Furthermore, dyes for improving the absorption of visible light having long wavelength to enhance the cell energy efficiency, and new-typed dyes capable of easily making the electron emission are under development and may be used.

The use of organic pigments such as coumarin, porphyrin, xanthene, riboflavin and triphenylmethane as dyes for a dye-sensitized solar cell has also been studied recently. Such organic pigments may be used alone or in combination with the Ru complex. Organic pigments are generally cost effective and abundant. Furthermore, the use of organic pigments makes it possible to improve the absorption of the long-wavelength visible rays, and enhance the cell energy efficiency.

In order to make the porous layer 30 naturally absorb the dye 40, the first electrode 10 coated with the porous layer 30 is dipped in a solution of the dye dissolved in alcohol for about 12 hours.

The second electrode 20 facing the first electrode 10 has a transparent substrate 21 and a two-layer conductive film comprising a first conductive layer 22 coated on the substrate 21, and a second conductive layer 23 coated on the first conductive layer 22. The substrate 21 is formed from a material such as PET, PEN, PC, PP, PI or TAC. The first conductive layer 22 is formed from a material such as ITO, FTO, ZnO-Ga₂O₃, ZnO-Al₂O₃, or SnO₂-Sb₂O₃. The second conductive layer 23 may be formed with platinum Pt or other precious metal such as gold, silver, ruthenium, rhodium, palladium, osmium or iridium.

In order to form the second conductive layer23 with Pt, a solution of H₂PtCl₆ dissolved in an organic solvent, for example, an alcohol such as methanol (MeOH), ethanol (EtOH) or isopropyl alcohol (IPA), is wet-coated onto the first conductive layer22 by way of spin coating, dip coating or flow coating, and heat-treated at about 400°C or more under an air or oxygen atmosphere. Other possible coating methods include physical vapor deposition (PVD) techniques such as electrolyte plating, sputtering or electron beam deposition.

The electrolyte 50 is impregnated between the first and the second electrodes 10 and 20, and uniformly diffused to the inside of the porous layer 30. The electrolyte 50 is formed with a iodide/triiodide redox couple, and receives electrons from the second electrode 20, and transfers them to the dye 40 through oxidation and reduction reactions. The voltage of the solar cell is determined by the energy level of the dye, and the difference in the level of oxidation and reduction of the electrolyte.

In a dye-sensitized solar cell according to the present invention, the first and second electrodes 10 and 20 are attached to each other using an adhesive 60a. Small holes penetrate the first and second electrodes 10 and 20 to allow a solution for forming the electrolyte 50 to be injected into the space between the two electrodes. Once the electrolyte has been injected, any holes are sealed using an adhesive 60b.

The adhesives 60a and 60b may be formed with a thermoplastic polymer film, such as SURLYN™. The thermoplastic polymer film is disposed between the two electrodes, and thermally pressed. Epoxy resin or ultraviolet (UV) hardening agent may also be used for adhesives 60a and 60b, and if so, such material is hardened upon heat treatment or UV treatment.

When the sunlight is incident upon the solar cell, the photons are first absorbed into the dye, and the dye is excited and oxidized to generate electrons. The electrons are transferred to the conduction band of the transition metal oxide forming the porous layer, and flow to the external circuit via the first electrode. Then, the electrons migrate to the second electrode. Meanwhile, the electrolyte receives electrons from the second electrode which is the counter electrode, and again transfers them to the dye through oxidation and reduction. The dye is reduced to the initial state. In this way, the solar cell is operated by the migration of electrons.

A dye-sensitized solar cell according to another embodiment of the present invention will be now explained in detail. In this embodiment, the basic components of the solar cell as well as the material for the porous layer are the same as those related to the previous embodiment except that the first and the second materials have different shapes. Accordingly, only the shapes of the first and the second materials will be now explained, and explanations for other structural components will be omitted.

Fig. 2 is a cross sectional view of a dye-sensitized solar cell according to another embodiment of the present invention where like reference numerals are used to indicate the same structural components as those related to the previous embodiment.

According to this embodiment of the invention, the porous layer 70 contains first and second materials 71 and 72 differing from each other in conduction band energy level. As shown in Fig. 2, the first material 71 is formed with particles having a nanometer-leveled mean particle diameter, and the second material 72 is formed as a thin film coated on the first material 71.

The nano particles of the first material 71 preferably have even particle diameters to achieve the desired porosity and surface roughness. That is, the nano particles of the first material 71 have a mean particle diameter of about 100nm or less, and preferably between about 10 and 40nm. The first material 71 may be formed of TiO₂. When the mean particle diameter is less than 10nm, the adhesive force thereof is too weak to form the porous layer in a stable manner. When the mean particle diameter exceeds 40nm, the surface area of the dye-absorbed porous layer is reduced so that the photoelectric conversion efficiency is decreased.

The second material 72 is formed on the first material 71 as a thin film with a thickness of between about 5 and 100nm.

Processes for fabricating a dye-sensitized solar cells with porous layers will be now explained in detail.

In order to make the dye-sensitized solar cells according to a first embodiment of the invention, a slurry is formed comprising the first and second materials with differing conduction band energy level as described above, and the slurry is coated onto a surface of the first electrode, thereby forming a porous layer.

Alternatively, according to a second embodiment of the invention, a slurry containing the first material is coated on a surface of the first electrode to form a porous layer, and the first electrode is dipped in a solution containing the second material. The first electrode is then dried to form a porous layer with the first and the second materials.

The process of forming a porous layer may be made in various other ways, which will be now explained in detail.

### Process 1

According to Process 1, particles of a first material and a second material are first mixed. Titanium oxide is used as the first material, and strontium oxide as the second material as follows.

First, about 5 to 30 wt.% of common anatase titanium oxide powder, and about 0.1 to 20 wt.% with respect to the titanium oxide of strontium oxide are added to about 70 to 95 wt.% of a solvent such as water, ethanol, methanol or mixtures thereof, and the mixture is mixed using a ball mill or a paint shake technique, thereby producing a titanium oxide and strontium oxide colloid mixture.

Then, PEG and PEO are added to the colloid mixture in an amount from about 5 to 50 wt.% of the titanium oxide, and diffused making a coating slurry capable of being coated by screen printing or a doctor blade.

A first electrode was formed by depositing ITO or FTO onto a glass substrate. The slurry is coated onto a surface of the first electrode to a thickness between about 1 and 50 µm using a screen printing technique or by doctor blade. The coated layer is heat-treated at 400°C under an air or oxygen atmosphere to volatize the solvent and the organic polymer. Consequently, a network is formed between the oxide particles, and the porous layer containing titanium oxide and strontium oxide that is securely adhered to the substrate.

### Process 2

According to Process 2, a porous layer is formed through hydrothermal synthesis.

First, about 5 to10 wt.% of titanium isopropoxide (Ti(i-Pro)₄) is added to a solvent such as water, ethanol, methanol, or a mixture thereof, and about 0.1 to 20 wt.% with respect to the titanium isopropoxide of strontium isopropoxide (Sr(i-Pro)₂) is added thereto by and dissolved therein. Nitric acid or acetic acid is added to form a solution with a pH between about 1 and 2. The solution is heated and reacted in an autoclave at between about 250 and 350°C, thereby forming a mixture of titanium oxide and strontium oxide with particle diameters between about 5 and 30nm.

Then, about 5 to 50 wt.% with respect to the titanium oxide of PEG and PEO are added to the mixture to form a slurry which is able to be coated by screen printing or a doctor blade.

The slurry is coated onto a first electrode as described above using a screen printing technique or a doctor blade to a thickness of about 1 to 50 µm. Then the coated layer is heat-treated at about 400°C or more under an air or oxygen atmosphere to volatilize the solvent and the organic polymer. Consequently, a network is formed between the oxide particles, and a porous layer containing titanium oxide and strontium oxide is formed while being securely adhered to the substrate.

### Process 3

According to Process 3 a porous layer is formed with a first material based on titanium oxide, and a second material based on strontium oxide.

First, about 5 to 30 wt.% of common anatase titanium oxide powder is added to a solvent comprising water, ethanol, methanol, or a mixture thereof, and about 5 to 50 wt.% with respect to the titanium oxide of PEG and PEO are added thereto. The mixture is diffused by way of ultrasonic treatment, a paint shaker, a mixer, a 3-roll mill or an apex mill to a slurry state with a viscosity such that it can be coated using a screen printing technique or a doctor blade.

The slurry is then coated onto a first electrode as described above using a screen printing technique or a doctor blade to a thickness of about 1 to 50 µm. Then the coated layer is heat-treated at about 400°C or more under an air or oxygen atmosphere to volatilize the solvent and the organic polymer. Consequently, a network is formed between the oxide particles, and a porous layer based on titanium oxide is formed while being securely adhered to the substrate.

Finally, the substrate with the titanium oxide-based porous layer is dipped in a solution of strontium nitrate (Sr(NO₃)₂) dissolved in water to a saturation of about 40 wt.%, and heat-treated at about 400°C or more under an air or oxygen atmosphere, thereby forming a porous layer containing titanium oxide and strontium oxide.

### Process 4

First about 5 to 10 wt.% of titanium isopropoxide (Ti(i-Pro)₄) is added to a solvent such as water, ethanol, methanol, or a mixture thereof, and nitric acid or acetic acid is added to form a solution with a pH between about 1 and 2. The solution is heated and reacted in an autoclave at about 250 to 350 °C, thereby forming a titanium oxide mixture with particle diameters of about 5 to 30 nm.

Then about 5 to 50 wt.% with respect to the titanium oxide of PEG and PEO are added to the mixture to form a slurry that can be coated by screen printing or a doctor blade.

The slurry is then coated onto a first electrode as described above by screen printing or a doctor blade to a thickness of about 1 to 50 µm. Then the coated layer is heat-treated at about 400°C or more under an air or oxygen atmosphere to volatilize the solvent and the organic polymer. Consequently, a network is formed between the oxide particles, and a porous layer containing titanium oxide is formed while being securely adhered to the substrate.

Finally, the substrate with the titanium oxide-based porous layer is dipped in a solution of strontium nitrate (Sr(NO₃)₂) dissolved in water to a saturation of about 40 wt.% for about 30 minutes, and heat-treated at about 400°C or more under an air or oxygen atmosphere to form a porous layer containing titanium oxide and strontium oxide.

### Example

Ruthenium dye molecules were absorbed to the first electrodes with the porous layers according to Processes 1 to 4. ITO and a platinum layer were sequentially deposited onto a glass substrate to thereby form a second electrode. The second electrode was aligned with the dye-absorbed first electrode such that the platinum layer faced the porous layer, and a polymer layer based on SURLYN™ (Du Pont) was disposed between the electrodes and the construct was pressed at about 100°C.

An electrolyte solution was injected through a small hole previously formed in the second electrode, and the hole was sealed using epoxy resin or SURLYN ™, thereby fabricating a dye-sensitized solar cell.
The electrolyte solution was prepared by dissolving 0.5M of tetrapropylammonium iodide or 0.8M of lithium iodide Lil in acetonitrile together with 0.05M of iodine.

### Comparative Example

A dye-sensitized solar cell was fabricated using a porous layer solely based on titanium oxide. All other processing conditions were performed according to the Example.

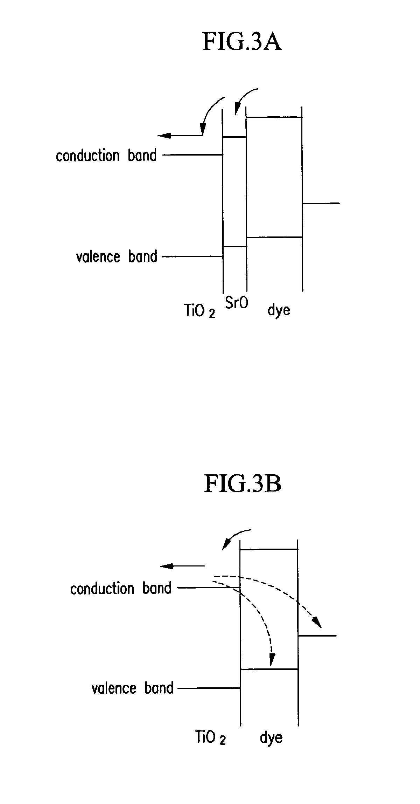

Fig. 3A illustrates the energy level of the porous layer and the dye of a dye-sensitized solar cell according to the Example, and Fig. 3B illustrates the energy level of the porous layer and the dye with a dye-sensitized solar cell according to the Comparative Example.

The porous layer illustrated in Fig. 3A contains a first material of titanium oxide, and a second material of strontium oxide. The porous layer illustrated in Fig. 3B contains just titanium oxide.

As shown in Figs. 3A and 3B, the conduction band energy level of strontium oxide is higher than the conduction band energy level of titanium oxide. When the excited electrons generated from the dye particles upon exposure to sunlight are transferred to the titanium oxide, the conduction band energy level of strontium oxide operates as an energy barrier between the dye particles and the titanium oxide. Accordingly, the strontium oxide prevents the recombination of electrons and holes, and fluently makes the transfer of electrons to the titanium oxide, thereby enhancing the photoelectric conversion efficiency.

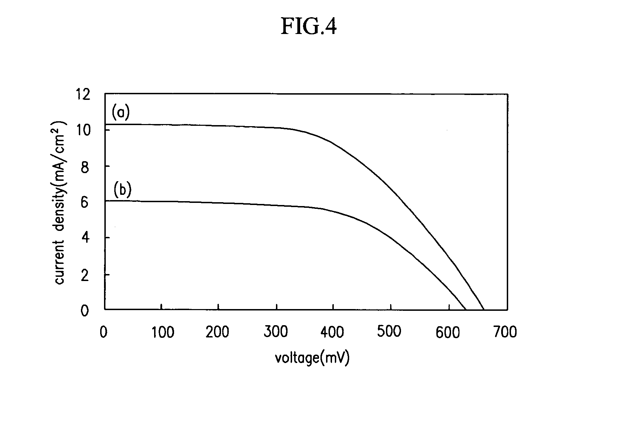

The photoelectric conversion efficiency of the solar cells was measured using a halogen lamp as a light source while correcting the intensity thereof to be 100mW/cm² with a Si-standard cell. The measured current-voltage characteristics are illustrated in Fig. 4 and Table 1.

Fig. 4 is a graph illustrating the relationship between voltage and current density of the solar cells of the Example and the Comparative Example. In Fig. 4, (a) illustrates the voltage-current curve of the dye-sensitized solar cell of the Example, and (b) illustrates the voltage-current curve of the dye-sensitized solar cell of the Comparative Example. The current and the voltage were measured using a light source of 100mW/cm² based on a Si-standard cell.

As shown in Fig. 4, the current density of the solar cell according to the Example was higher than that according to the Comparative Example, and it was estimated that the photoelectric conversion efficiency of the former cell was much higher.

**Table 1**

| | Open circuit voltage (Voc) | Short circuit current (Jsc) | Fill factor (FF) | Photoelectric conversion |
|---|---|---|---|---|
| Example | 658 | 10.29 | 0.547 | 3.70 |
| Comparative Example | 607 | 7.67 | 0.573 | 2.67 |

As shown in Table 1, the open circuit voltage (Voc) and the short circuit current (Jsc) of the dye-sensitized solar cell according to the Example were significantly enhanced compared to those of the cell according to the Comparative Example while showing only a small reduction in the fill factor. The photoelectric conversion efficiency of the solar cell of the Example was enhanced by 35% or more over the solar cell of the Comparative Example.

Instead of strontium oxide, it is possible to use metal oxides or non-oxides with an energy level higher than the conduction band energy level of titanium oxide. Suitable metal oxides include zirconium oxide (ZrO₂), zinc oxide (ZnO) and barium oxide (BaO), and the non-oxides include gallium phosphide (GaP), silicon carbide (SiC), and cadmium sulfide (CdS). It is preferable to use oxides with higher stability.

Although preferred embodiments of the present invention have been described in detail hereinabove, it should be clearly understood that many variations and/or modifications of the basic inventive concept herein taught may appear to those skilled in the art, and such embodiments will still fall within the spirit and scope of the present invention, as defined in the appended claims.

## Claims

1. A dye-sensitized solar cell comprising:
a first electrode of a light transmission material;
a porous layer formed on a surface of the first electrode with first and second materials differing from each other in conduction band energy level;
a dye absorbed on the porous layer;
a second electrode facing the the porous layer of the first electrode; and
an electrolyte impregnated between the first and the second electrodes.

2. The dye-sensitized solar cell of claim 1 wherein the first material comprises a metal oxide and the second material has a conduction band energy level higher than the conduction band energy level of the first material.

3. The dye-sensitized solar cell of claim 2 wherein the first material is selected from the group consisting of Ti oxide, Zr oxide, Sr oxide, Zn oxide, In oxide, Ir oxide, La oxide, V oxide, Mo oxide, W oxide, Sn oxide, Nb oxide, Mg oxide, Al oxide, Y oxide, Sc oxide, Sm oxide, Ga oxide, SrTi oxide, and combinations thereof.

4. The dye-sensitized solar cell of claim 2 wherein the second material is selected from the group consisting of metal oxides, GaP, SiC, CdS, and combinations thereof.

5. The dye-sensitized solar cell of claim 2 wherein the second material is selected from the group consisting of Ti oxide, Zr oxide, Sr oxide, Zn oxide, In oxide, Ir oxide, La oxide, V oxide, Mo oxide, W oxide, Sn oxide, Nb oxide, Mg oxide, Al oxide, Y oxide, Sc oxide, Sm oxide, Ga oxide, SrTi oxide, GaP, SiC, CdS, and combinations thereof.

6. The dye-sensitized solar cell of claim 2 wherein the first material comprises Ti oxide and the second material comprises a material selected from the group consisting of Sr oxide, Nb oxide and Zn oxide.

7. The dye-sensitized solar cell of claim 2 wherein the conduction band energy level of the first material is between about -8.5 and -3.5 eV, and the conduction band energy level of the second material is between about -8.0 and -3.0eV.

8. The dye-sensitized solar cell of claim 1 wherein the first and second materials each comprise particles having a mean particle diameter of about 100nm or less.

9. The dye-sensitized solar cell of claim 8 wherein the first and the second materials each comprise particles having a mean particle diameter of between about 10 and 40nm.

10. The dye-sensitized solar cell of claim 1 wherein the dye comprises a metal complex of Ru and another metal selected from the group consisting of Al, Pt, Pd, Eu, Pb and Ir.

11. The dye-sensitized solar cell of claim 1 wherein the porous layer contains conductive particles or light scattering particles.

12. The dye-sensitized solar cell of claim 1 wherein the first electrode comprises:
a transparent substrate comprising a material selected from the group consisting of polyethylene terephthalate (PET), polyethylene naphthalate (PEN), polycarbonate (PC), polypropylene (PP), polyimide (PI) and triacetate cellulose (TAC); and
a conductive film formed on the transparent substrate comprising a material selected from the group consisting of indium tin oxide (ITO), fluorine tin oxide (FTO), ZnO-Ga₂O₃, ZnO-Al₂O₃ and SnO₂-Sb₂O₃.

13. The dye-sensitized solar cell of claim 1 wherein the second electrode comprises:
a transparent substrate comprising a material selected from the group consisting of polyethylene terephthalate (PET), polyethylene naphthalate (PEN), polycarbonate (PC), polypropylene (PP), polyimide (PI) and triacetate cellulose (TAC); and
a conductive film comprising first and second conductive layers, wherein the first conductive layer comprising a material selected from the group consisting of indium tin oxide (ITO), fluorine tin oxide (FTO), ZnO-Ga₂O₃, ZnO-Al₂O₃ and SnO₂-Sb₂O₃, and the second conductive layer comprises a precious metal.

14. A dye-sensitized solar cell comprising:
a first electrode of a light transmission material;
a porous layer formed on a surface of the first electrode comprising a first material and a second material layered over the first material, wherein each of the first and second layers has a different conduction band energy level from the other;
a dye absorbed on the porous layer;
a second electrode facing the porous layer of the first electrode; and
an electrolyte impregnated between the first and the second electrodes.

15. The dye-sensitized solar cell of claim 14 wherein the second material is layered over the first material as a thin film.

16. The dye-sensitized solar cell of claim 15 wherein the second material has a thickness of from about 5 to 100 nm.

17. A method of fabricating a dye-sensitized solar cell comprising:
preparing first and second electrodes of transparent materials;
combining first and second materials with different conduction band energy levels from one another;
forming a porous layer containing the first and second materials by coating the combination of the first and second materials onto a surface of the first electrode;
absorbing a dye on the porous layer;
aligning the second electrode with the first electrode such that the second electrode faces the porous layer of the first electrode; and
injecting an electrolyte between the first electrode and second electrode.

18. The method of claim 17 wherein:
the step of combining the first and second materials comprises mixing the first and second materials in a solvent to form a mixture, and adding a polymer to the mixture to form a slurry; and
the step of forming a porous layer comprises coating the slurry onto the first electrode to form a coated electrode and drying the coated electrode.

19. The method of claim 18 wherein:
the step of forming a mixture comprises adding about 5 to 30 wt.% of titanium oxide and about 0.1 to 20 wt.% with respect to the titanium oxide of strontium oxide to about 70 to 95wt.% of a solvent selected from the group consisting of water, ethanol, methanol and combinations thereof;
the step of forming a slurry comprises adding about 5 to 50 wt% with respect to the titanium oxide of a polymer selected from the group consisting of polyethylene glycol, polyethylene oxide, and combinations thereof to the mixture; and
the step of forming a porous layer comprises: coating the slurry onto the first electrode at a thickness of about 1 to 50 µm and drying the coated electrode.

20. The method of claim 17 wherein the step of combining the first and second materials comprises mixing and reacting precursors of the first and second materials in a solvent to form a mixture of the first and second materials , and adding a polymer to the mixture to form a slurry; and
the step of forming a porous layer comprises coating the slurry onto the first electrode to form a coated electrode and drying the coated electrode.

21. The method of claim 20 wherein:
the step of forming a mixture comprises adding about 5 to 10 wt.% of titanium isopropoxide (Ti(i-Pro)₄) and about 0.1 to 20 wt.% with respect to the titanium isopropoxide (Ti(i-Pro)₄) of strontium isopropoxide (Sr(i-Pro)₂) to about 90 to 95 wt.% of a solvent selected from the group consisting of water, ethanol, methanol and combinations thereof and reacting the solution at about 250 to 350 °C at a pH of about 1 to 2 to make the mixture comprising titanium oxide and strontium oxide as the first and second materials; and
the step of forming a slurry comprises adding about 5 to 50 wt.% with respect to the titanium oxide of a polymer selected from polyethylene glycol, polyethylene oxide, and mixtures thereof to the mixture; and
the step of forming a porous layer comprises coating the slurry onto the first electrode at a thickness of about 1 to 50 µm and drying the coated electrode.

22. The method of claim 18 wherein the step of forming a porous layer comprises heat-treating the coated electrode at about 400°C or more under an air or oxygen atmosphere.

23. A method of fabricating a dye-sensitized solar cell comprising the steps of:
preparing first and second electrodes of transparent materials;
preparing a first mixture comprising a first solvent and a first material or a precursor to the first material, wherein the first material has a conduction band energy level;
preparing a second mixture comprising a second solvent and a second material or a precursor to the second material, wherein the second material has a conduction band energy level different from the conduction band energy level of the first material;
coating the first electrode with the first mixture to form a first-coated first electrode;
drying the first-coated first electrode to form a porous layer comprising the first material on the first electrode;
dipping the first electrode into the second mixture to form a second-coated first electrode;
drying the second-coated first electrode to form a porous layer comprising the first and second materials on the first electrode;
absorbing a dye on the porous layer;
aligning the second electrode with the first electrode such that the second electrode faces the porous layer of the first electrode; and
injecting an electrolyte between the first and second electrodes.

24. The method of claim 23 wherein the step of forming the first mixture further comprises adding a polymer.

25. The method of claim 24 wherein the step of forming the first mixture comprises adding about 5 to 30 wt.% of titanium oxide, and about 5 to 50 wt.% with respect to the titanium oxide of a polymer selected from polyethylene glycol, polyethylene oxide, and combinations thereof, to about 70 to 95 wt.% of a solvent selected from the group consisting of water, ethanol, methanol and combinations thereof; and the step of coating the first electrode with the first mixture further comprises coating the first mixture onto a surface of the first electrode to a thickness of about 1 to 50 µm.

26. The method of claim 25 wherein the second mixture comprises 40 wt.% of strontium nitrate (Sr(NO₃)₂) as the precursor to the second material in a solvent of water, and the step of dipping the first electrode into the second mixture is performed for about 30 minutes.

27. The method of claim 23 wherein the first mixture comprises a precursor of the first material and a first solvent, the method further comprising the step of heating the first mixture to form the first material.

28. The method of claim 27 wherein the first mixture comprises about 5 to 10 wt.% of titanium isopropoxide (Ti(i-Pro)₄) in about 90 to 95 wt.% of a solvent selected from the group consisting of water, ethanol, methanol and combinations thereof, and the step of heating the first mixture comprises heating the first mixture to about 250 to 350°C at a pH of about 1 to 2 to form a mixture of titanium dioxide, wherein about 5 to 50wt.% with respect to the titanium oxide of a polymer selected from polyethylene glycol, polyethylene oxide, and combinations thereof is added to the mixture of titanium oxide before the first mixture is coated onto the surface of the first electrode and the step of coating the first electrode with the first mixture comprises coating the first electrode to a thickness of about 1 to 50 µm.

29. The method of claim 28 wherein the second mixture comprises 40 wt.% of strontium nitrate (Sr(NO₃)₂) as the precursor to the second material in a solvent of water, and the step of dipping the first electrode into the second mixture is performed for about 30 minutes.

30. The method of claim 23 wherein the step of drying the first-coated first electrode to form a porous layer comprising the first material on the first electrode comprises heat-treating the first-coated first electrode at about 400°C or more under an air or oxygen atmosphere.
